# EUROPEAN PATENT APPLICATION

(11) **EP 2 355 630 A2**
(43) Date of publication of application: **10.08.2011**
(21) Application number: 11152795.8
(22) Date of filing: 31.01.2011
(51) Int. Cl.: H05K 1/02

(54) **Circuit board with heat dissipating structure and manufacturing method thereof**

(30) Priority: 01.02.2010 TW 099102880
(71) Applicant: Avermedia Technologies, Inc., Taipei (TW)
(72) Inventor: Chang, Sheng-Cheng, 235, Taipei (TW); Chiang, Chien-Chung, 235, Taipei (TW); Hsu, Wei-Lun, 235, Taipei (TW); Chen, Jin-Fu, 235, Taipei (TW); Yeh, Chien-Ming, 235, Taipei (TW)
(74) Representative: Lang, Christian

(57) **Abstract**

A circuit board (1) with a heat dissipating structure is provided. A first grounding conductor layer (210, 410) is formed on a first surface (21, 41) of a substrate (2, 4). A first insulting layer (211, 411) is formed on the first grounding conductor layer (210, 410) and defines a number of circuit element pin openings (212, 412) and a plurality of heat dissipating openings (213, 413) therein so that the first grounding conductor layer (210, 410) is exposed from the circuit element pin openings (212, 412) and the heat dissipating openings (213, 413). A number of solder balls (214, 414) are disposed in the circuit element pin openings (212, 412) and contacted with the first grounding conductor layer (210, 410). A number of heat dissipating structures (215, 415) are disposed in the heat dissipating openings (213, 413) and contacted with the first grounding conductor layer (210, 410). The heat dissipating structures (215, 415) and the solder balls (214, 414) have an identical material. The method for manufacturing the circuit board is also provided.

## Description

### FIELD OF THE INVENTION

The present invention relates to a circuit board with a heat dissipating structure and a manufacturing method thereof, and more particularly to a circuit board with a heat dissipating structure and a manufacturing method thereof, which can be applied to a miniaturized electronic apparatus.

### BACKGROUND OF THE INVENTION

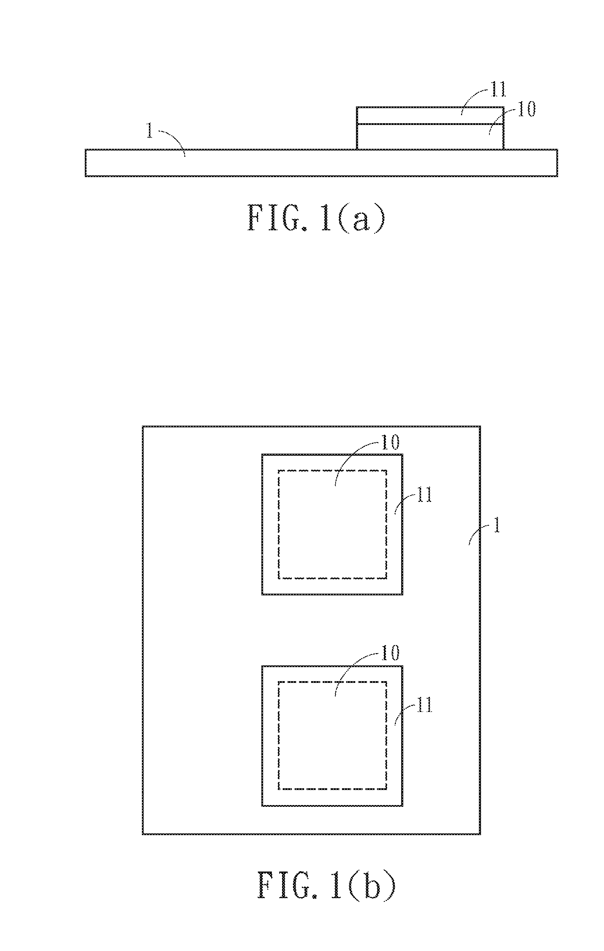

Heat dissipating problem is brought to circuit designers or users while electronic products are designed to have high operation speeds but have small sizes. FIGS. 1A and 1B illustrate schematic views of electronic products with heat dissipating elements disposed on a circuit board. Referring to FIGS. 1A and 1B, a high heating element 10, i.e., a high speed operation integrated circuit chip or a light emitting diode (LED) chip, is disposed on a circuit board 1. The high heat is generated by the high heating element 10 so that a temperature is increased, thereby affecting other electronic elements (not shown) on the circuit board 1 or the circuit board 1 itself. Thus, typically, a heat dissipating element 11, i.e., a heat dissipating fan or a heat dissipating fins, is disposed on the top of the high heating element 10. However, the utility of the heat dissipating element 11 not only increases the cost but also enlarge the size of the corresponding electronic product.

Therefore, what is needed is a circuit board with a heat dissipating structure and a manufacturing method thereof so as to overcome the above disadvantages.

### SUMMARY OF THE INVENTION

Therefore, the object of the present invention is to provide a circuit board with a heat dissipating structure and a manufacturing method thereof to enhance the heat dissipating efficiency without increasing the cost and the size of an electronic product.

The present invention provides a circuit board with a heat dissipating structure is provided. A first grounding conductor layer is formed on a first surface of a substrate. A first insulting layer is formed on the first grounding conductor layer and defines a number of circuit element pin openings and a plurality of heat dissipating openings therein so that the first grounding conductor layer is exposed from the circuit element pin openings and the heat dissipating openings. A number of solder balls are disposed in the circuit element pin openings and contacted with the first grounding conductor layer. A number of heat dissipating structures are disposed in the heat dissipating openings and contacted with the first grounding conductor layer. The heat dissipating structures and the solder balls have an identical material.

In one embodiment, the substrate further has a second surface. A second grounding conductor layer is formed on the second surface of the substrate. A second insulting layer is formed on the second grounding conductor layer. The second insulting layer defines a number of circuit element pin openings and a number of heat dissipating openings therein so that the second grounding conductor layer is exposed from the circuit element pin openings and the heat dissipating openings. A number of solder balls are disposed in the circuit element pin openings and contacted with the second grounding conductor layer. A number of heat dissipating structures are disposed in the heat dissipating openings and contacted with the second grounding conductor layer. The heat dissipating structures and the solder balls have an identical material.

In one embodiment, a material of each of the first grounding conductor layer and the second grounding conductor layer is a copper foil, and the material of the plurality of solder balls and the plurality of heat dissipating structures is a solder paste.

In one embodiment, each of the heat dissipating structures is a projection.

The present invention provides a manufacturing method a circuit board with a heat dissipating structure. A substrate having a first surface is provided. A first grounding conductor layer is formed on the first surface of the substrate. A first insulting layer is formed on the first grounding conductor layer. A number of circuit element pin openings and a number of heat dissipating openings are defined in the first insulting layer so that the first grounding conductor layer is exposed from the circuit element pin openings and the heat dissipating openings. A number of solder balls and a number of heat dissipating structures are formed on the first grounding conductor layer by printing a solder material through the circuit element pin openings and the heat dissipating openings.

In one embodiment, the substrate further has a second surface. A second grounding conductor layer is formed on the second surface of the substrate. A second insulting layer is formed on the second grounding conductor layer. The second insulting layer defines a number of circuit element pin openings and a number of heat dissipating openings therein so that the second grounding conductor layer is exposed from the circuit element pin openings and the heat dissipating openings. A number of solder balls and a number of heat dissipating structures are formed in the circuit element pin openings and the heat dissipating openings.

In one embodiment, a material of each of the first grounding conductor layer and the second grounding conductor layer is a copper foil, and the material of the plurality of solder balls and the plurality of heat dissipating structures is a solder paste.

In one embodiment, the step of forming the plurality of solder balls and the plurality of heat dissipating structures includes the following steps. A print mask with a number of print openings corresponding to the circuit element pin openings and the heat dissipating openings is provided. The solder material is printed by using the print mask so that the solder material passes through the circuit element pin openings and the heat dissipating openings via the print openings to be printed on the first grounding conductor layer.

Other objectives, features and advantages of the present invention will be further understood from the further technological features disclosed by the embodiments of the present invention wherein there are shown and described preferred embodiments of this invention, simply by way of illustration of modes best suited to carry out the invention.

### BRIEF DESCRIPTION OF THE DRAWINGS

The above objects and advantages of the present invention will become more readily apparent to those ordinarily skilled in the art after reviewing the following detailed description and accompanying drawings, in which:

FIGS. 1A and 1B illustrate schematic views of typical electronic elements with at least a heat dissipating structure disposed on a circuit board;

FIG. 2 illustrates a schematic view of a circuit board with a heat dissipating structure in accordance with a first embodiment of the present invention;

FIG. 3 illustrates a schematic view of a circuit board with a heatdissipating structure in accordance with a first embodiment of the present invention;

FIGS. 4A to 4D illustrate a process flow of a method for manufacturing the circuit board with a heat dissipating structure shown in FIG 2;

FIGS. 5A to 5D illustrate schematic views of a number of heat dissipating openings;

FIGS. 6A to 6B illustrate schematic views of the heat dissipating structures;

FIG. 6C illustrates a top view of an arrangement of the heat dissipating structures;

FIGS. 7A to 7C illustrate a process flow of a method for manufacturing the circuit board with the heat dissipating structure in the second embodiment of the present invention;

FIGS. 8A to 8B illustrate schematic views of temperature testing points arranged on both sides of a conventional circuit board without the heat dissipating structure; and

FIGS. 8C to 8D illustrate schematic views of temperature testing points arranged on both sides of the circuit board with the heat dissipating structure.

### DETAILED DESCRIPTION OF PREFERRED EMBODIMENTS

The present invention will now be described more specifically with reference to the following embodiments. It is to be noted that the following descriptions of preferred embodiments of this invention are presented herein for purpose of illustration and description only. It is not intended to be exhaustive or to be limited to the precise form disclosed.

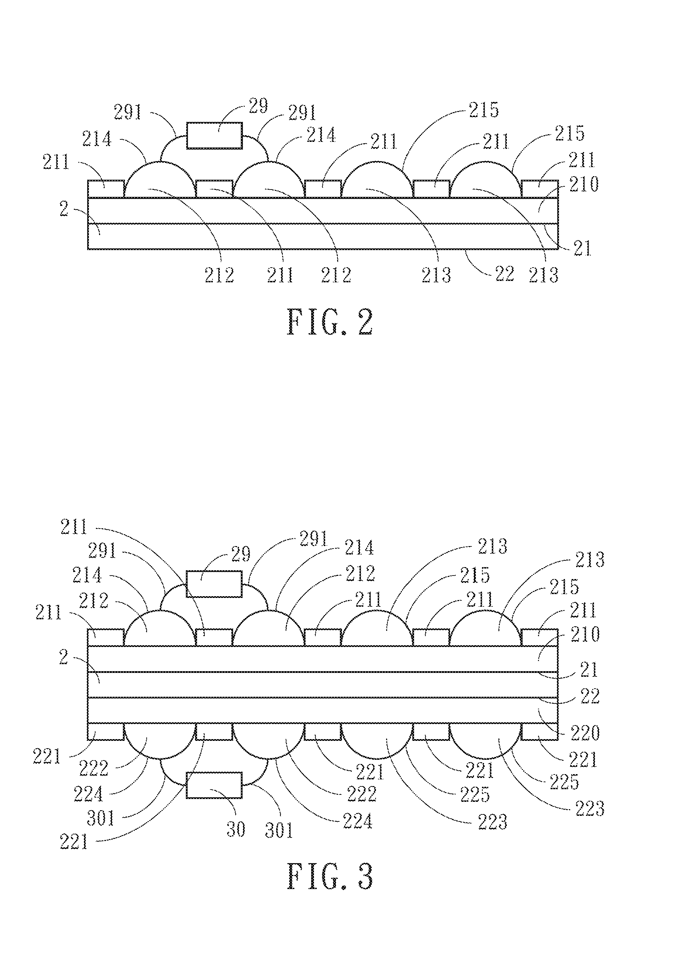

FIG. 2 illustrates a schematic view of a circuit board with a heat dissipating structure in accordance with a first embodiment of the present invention. Referring to FIG. 2, in the present embodiment, the circuit board with a heat dissipating structure includes a substrate 2, a first grounding conductor layer 210, a first insulting layer 211 and an electronic element 29. The first grounding conductor layer 210, the first insulting layer 211 and the electronic element 29 are disposed on the substrate 2.

As depicted in FIG. 2, the substrate 2, can be a printed circuit board (PCB), which can includes multiple electrically conductive/ or insulting layers. The printed circuit board can be a single side circuit board, double side circuit board or a multilayer circuit board. The substrate has a first surface 21 and a second surface 22 on an opposite side of the substrate 2 to the first surface 21. The first grounding conductor layer 210 is formed on the first surface 21 of the substrate 2. The first grounding conductor layer 210 can be made of copper foil or other electrically conductive materials. And then, the first insulting layer 211 is formed on the first grounding conductor layer 210. A number of openings are defined in the first insulting layer 211 so that the first grounding conductor layer 210 is exposed from the openings. In the present embodiment, a number of circuit element pin openings 212 are defined in the first insulting layer 211. Meanwhile, a number of heat dissipating openings 213 are also defined in the first insulting layer 211.

Still, referring to FIG. 2, each of the circuit element pin openings 212 is filled with a solder ball 214 and accordingly the solder ball 214 is directly contacted with the first grounding conductor layer 210. Moreover, the electronic element 29 has a number of pins 291 and the pins 291are soldered to the solder ball 214. Through the solder ball 214, the pins 291 of the electronic element 29 are electrically connected to the first grounding conductor layer 210.

As depicted in FIG. 2, each of the heat dissipating openings 213 is filled with a heat dissipating structure 215. A material of the heat dissipating structure 215 and a material of the solder ball 214 are identical. The heat dissipating structure 215 is directly contacted with the first grounding conductor layer 210. In other words, comparative to the solder ball 214, the pins 291 are not soldered to the heat dissipating structure 215. Because the heat dissipating structures 215 are formed in the heat dissipating openings 213 and directly contacted with the first grounding conductor layer 210, the heat generated by the electronic element 29 can be further transmitted to the heat dissipating structures 215 sequentially through the solder balls 214 and the first grounding conductor layer 210, thereby enlarging a heat dissipating area and increasing a heat dissipating efficiency.

FIG. 3 illustrates a schematic view of a circuit board with a heat dissipating structure in accordance with a second embodiment of the present invention. A circuit board with a heat dissipating structure in the second embodiment is similar to the circuit board with the heat dissipating structure in the first embodiment except that a second grounding conductor layer 220 and a second insulting layer 221 are disposed on a second surface 22 of a substrate 2. In detail, the second grounding conductor layer 220 can be made of copper foil or other electrically conductive materials. The second grounding conductor layer 220 is directly formed on the second surface 22 of the substrate 2 and the second insulting layer 221 is then formed on the second grounding conductor layer 220. A number of openings are also defined in the second insulting layer 221 so that the second grounding conductor layer 220 is exposed from the openings. In the present embodiment, a number of circuit element pin openings 222 and a number of heat dissipating openings 223 are defined in the second insulating layer 221.

As depicted in FIG. 3, each of the circuit element pin openings 222 is filled with a solder ball 224 and accordingly the solder ball 214 is directly contacted with the second grounding conductor layer 220. Moreover, the electronic element 30 has a number of pins 301. The pins 301 are soldered to the solder ball 224. Through the solder ball 214, the pins 301 of the electronic element 30 are electrically connected to the second grounding conductor layer 220.

As depicted in FIG. 3, each of the heat dissipating openings 223 is filled with a heat dissipating structure 225. A material of the heat dissipating structure 225 and a material of the solder ball 224 are identical. The heat dissipating structure 225 is directly contacted with the second grounding conductor layer 220. In other words, comparative to the solder ball 224, the pins 301 are not soldered to the heat dissipating structure 225. Because the heat dissipating structures 225 are formed in the heat dissipating openings 223 and directly contacted with the second grounding conductor layer 210, the heat generated by the electronic element 30 can be further transmitted to the heat dissipating structures 225 sequentially through the solder balls 224 and the second grounding conductor layer 220, thereby enlarging a heat dissipating area and increasing a heat dissipating efficiency. In summary, in the present embodiment, the heat dissipating structures 215, 225 are respectively disposed on the first surface 21 and the second surface 22 of the substrate 2.

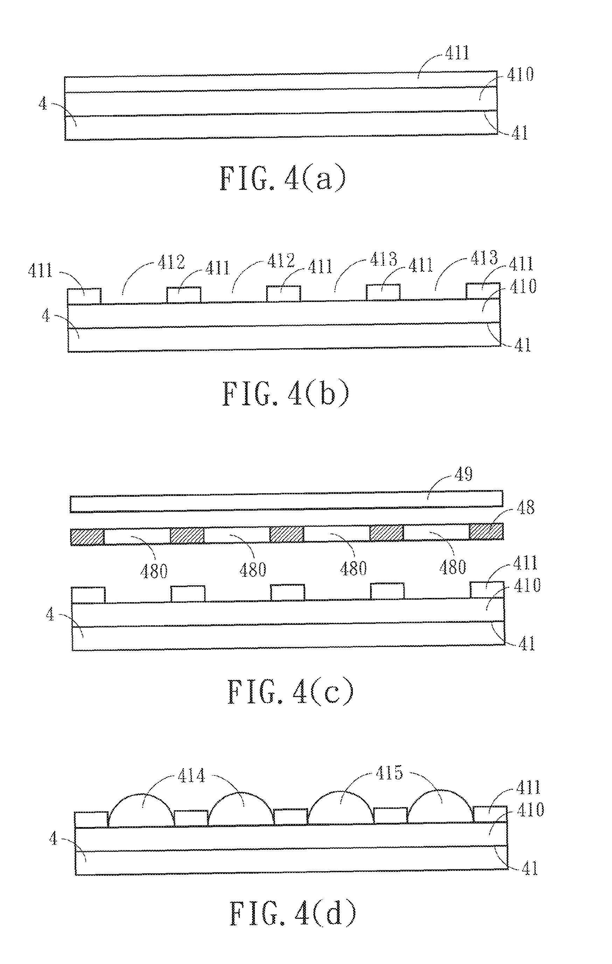

FIGS. 4A to 4D illustrate a process flow of a manufacturing method of the circuit board with the heat dissipating structure in the first embodiment of the present invention. Referring to FIG. 4A, a substrate 4 is provided. The substrate 4 includes a first grounding conductor layer 410 and a first insulting layer 411. The first grounding conductor layer 410 is formed on a first surface 41 of the substrate 4, and the first insulating layer 411 is formed on the first grounding conductor layer 410. Referring to FIG. 4B, a number of openings are defined in the first insulting layer 411 so that the first grounding conductor layer 410 is exposed from the openings. In the present embodiment, a number of circuit element pin openings 412 and a number of heat dissipating openings 413 are defined in the first insulating layer 411. Referring to FIG. 4C, a solder material 49 is printed on the first grounding conductor layer 410 via a print mask 48. The print mask 48 defines a number of print openings 480 corresponding to the circuit element pin openings 412 and the heat dissipating openings 413 in the first grounding conductor layer 410. Thus, the solder material 49 passes through the circuit element pin openings 412 and the heat dissipating openings 413 and are printed on the first grounding layer 410 through the circuit element pin openings 412 and the heat dissipating openings 413. As a result, referring to FIG. 4D, a number of solder balls 414 and a number of heat dissipating structures 415 are respectively formed in the circuit element pin openings 412 and the heat dissipating openings 413 and on the first grounding layer 410.

As described above, because the heat dissipating structures 415 in the heat dissipating openings 413 the solder balls 414 in the circuit element pin openings 412 are formed simultaneously, it is unnecessary to increase any step. Moreover, because the heat dissipating structures 415 are formed in the heat dissipating openings 413, a thickness of the circuit board with the heat dissipating structures 415 is not increased. In summary, the heat dissipating efficiency can be increased by using a region where the electronic component does not be mounted to dispose heat dissipating openings 413 and the heat dissipating structures 415.

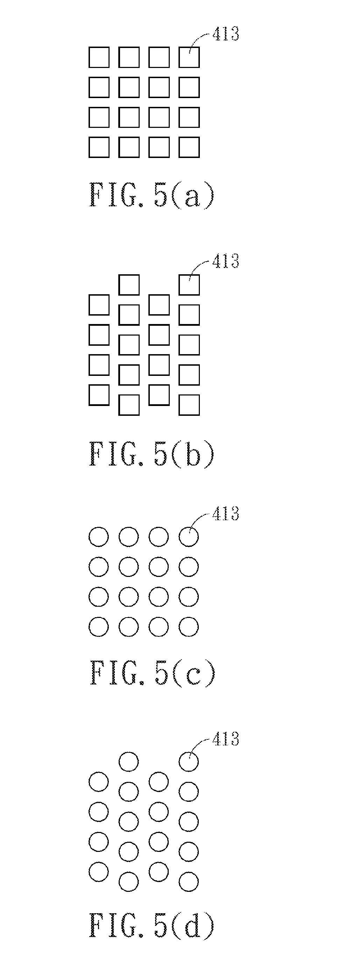

FIGS. 5A to 5D illustrate schematic views of a number of heat dissipating openings. Referring to FIGS. 5A to 5D, a configuration of each of the heat dissipating openings 413 can be either a square or a circle. Moreover, it is noted that a higher heat dissipating efficiency is accompanied with higher arrangement density of the heat dissipating openings 413.

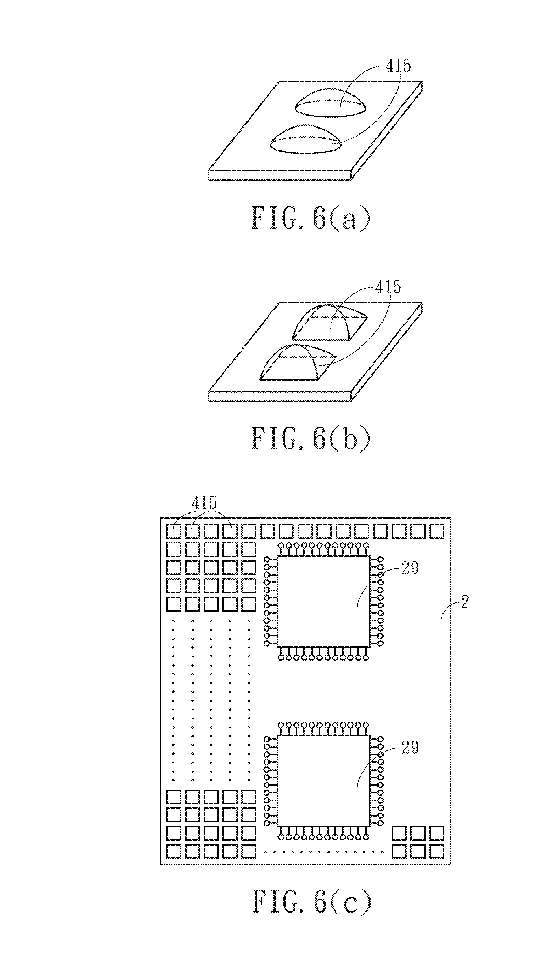

FIGS. 6A and 6B illustrate schematic views of the heat dissipating structures 415. It is noted that the heat dissipating efficiency is related to the configuration of the heat dissipating structures 415. That is, a higher heat dissipating efficiency is obtained if the heat dissipating structures 415 has a larger surface. In the present embodiment, each of the heat dissipating structures 415 is a projection. FIG. 6C illustrates a top view of an arrangement of the heat dissipating structures 415. While designing a layout of the circuit board, a region where the electronic component does not be mounted is processed in a manner such that a grounding conductor layer (e.g., a cooper foil) is disposed. Thus, the heat dissipating openings 413 and the heat dissipating structures 415 can be disposed on the circuit board. The more the heat dissipating structures 415, the higher the heat dissipating efficiency.

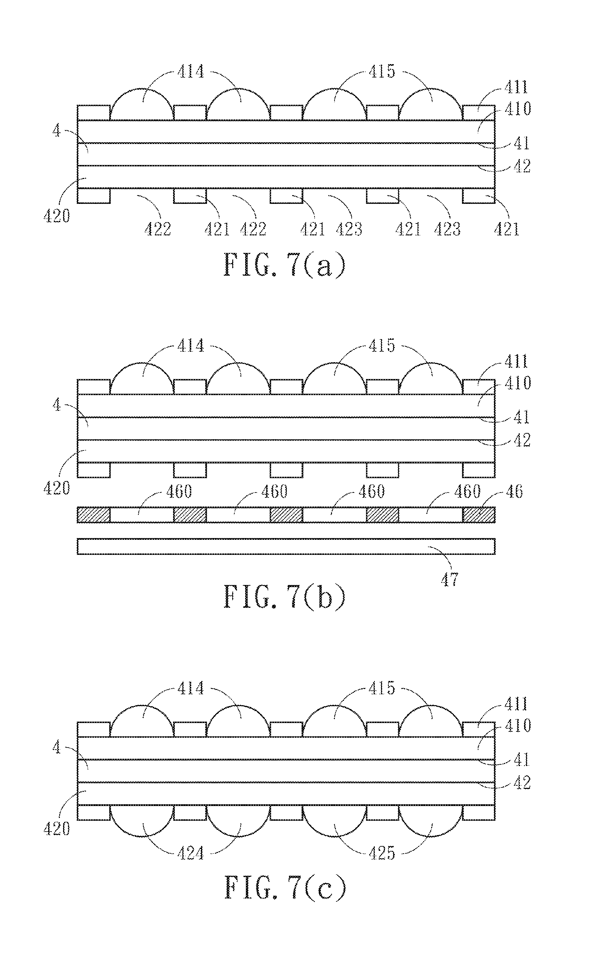

FIGS. 7A to 7C illustrate a process flow of a method for manufacturing the circuit board with the heat dissipating structure in the second embodiment of the present invention. The method is similar to the method for manufacturing the circuit board with the heat dissipating structure in the first embodiment except that the following steps are continually performed after the heat dissipating structures 415 are formed. Referring to FIG. 7A, a second grounding conductor layer 420 is disposed on a second surface 42 of the substrate 4, and a second insulating layer 421 is formed on the second grounding conductor layer 420. Then, a number of openings are defined in the second insulting layer 421 so that the second grounding conductor layer 429 is exposed from the openings. In the present embodiment a circuit element pin openings 422 and a number of heat dissipating openings 423 are defined. Referring to FIG. 7B, the solder material 49 is printed on the second grounding conductor layer 420 via a print mask 46. Because the print mask 46 includes a number of print openings 460 corresponding to the circuit element pin openings 422 and the heat dissipating openings 423 in the second grounding conductor layer 420. Thus, the solder material 49 passes through the circuit element pin openings 422 and the heat dissipating openings 423 and are printed on the second grounding conductor layer 420 through the circuit element pin openings 422 and the heat dissipating openings 423. As a result, referring to FIG. 7C, a number of solder balls 424 and a number of heat dissipating structures 425 are respectively formed in the circuit element pin openings 422 and the heat dissipating openings 423 and on the second grounding layer 420.

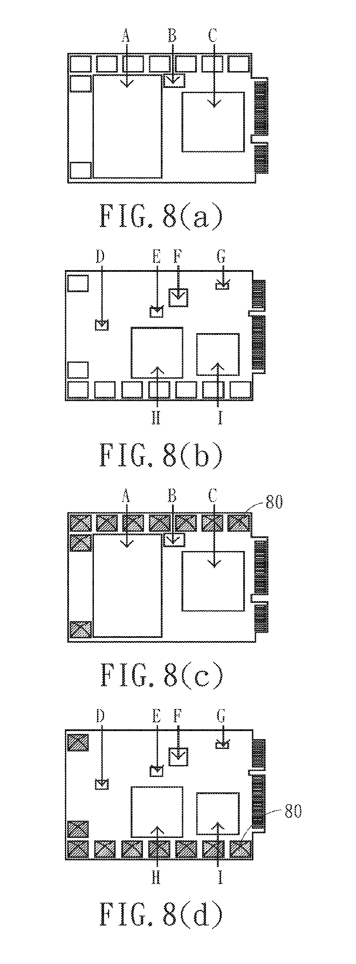

FIGS. 8A to 8B illustrate schematic views of temperature testing points arranged on both sides of a conventional circuit board without the heat dissipating structure. FIGS. 8C to 8D illustrate schematic views of temperature testing points arranged on both sides of the circuit board with the heat dissipating structure in accordance with the embodiments of the present invention. As depicted in FIG. 8A, temperature testing points A, B and C are arranged on a front side of the conventional circuit board. As depicted in FIG. 8B, temperature testing points D, E, F, G, H and I are arranged on a back side of the conventional circuit board. As depicted in FIG. 8C, temperature testing points A, B and C are arranged on a front side of the circuit board with the heat dissipating structures 80. As depicted in FIG. 8D, temperature testing points D, E, F, G, H and I are arranged on a back side of the circuit board with the heat dissipating structures 80.

The following table is a temperature testing result indicating the temperature differences between the conventional circuit board without the heat dissipating structure and the circuit board with the heat dissipating structure. The temperatures are tested under a condition that an operating temperature (Ta) is 50°C, a gas speed is 0, and a consuming power is 3W.

| Testing Point | Circuit board without the heat dissipating structure | Circuit board with the heat dissipating structure | Temperature difference |
|---|---|---|---|
| A | 88.9 | 87.1 | -1.8 |
| B | 77.9 | 76.1 | -1.8 |
| C | 78.9 | 77.7 | -1.2 |
| D | 83.8 | 81.8 | -2.0 |
| E | 82.1 | 80.0 | -2.1 |
| F | 81.6 | 79.5 | -2.1 |

According to the testing result indicated in the table, the average temperature of the circuit board with the heat dissipating structures 80 is lower 1.8 °C than that of the conventional circuit board. Thus, a thermal resistance is equal to 0.6°C/W (i.e.,1.8°C/3W). In addition, the solder material 49 can be either a solder paste or an eutectic alloy.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A circuit board (1) with a heat dissipating structure, **characterized in that** the circuit board (1) comprises:
a substrate (2, 4) having a first surface (21, 41);
a first grounding conductor layer (210, 410) formed on the first surface (21, 41) of the substrate (2, 4);
a first insulting layer (211, 411) formed on the first grounding conductor layer (210, 410), the first insulting layer (211, 411) defining a plurality of circuit element pin openings (212, 412) and a plurality of heat dissipating openings (213, 413) therein so that the first grounding conductor layer (210, 410) is exposed from the plurality of circuit element pin openings (212, 412) and the plurality of heat dissipating openings (213, 413);
a plurality of solder balls (214, 414) disposed in the plurality of circuit element pin openings (212, 412) and contacted with the first grounding conductor layer (210, 410); and
a plurality of heat dissipating structures (215, 415) arranged disposed in the plurality of heat dissipating openings (213, 413) and contacted with the first grounding conductor layer (210, 410), the plurality of heat dissipating structures (215, 415) and the plurality of solder balls (214, 414) have an identical material.

2. The circuit board (1) with the heat dissipating structure according to claim 1, **characterized in that** the substrate (2, 4) further has a second surface (22, 42) and the circuit board (1) with the heat dissipating structure further comprises:
a second grounding conductor layer (220, 420) formed on the second surface (22, 42) of the substrate (2, 4);
a second insulting layer (221, 421) formed on the second grounding conductor layer (220, 420), the second insulating layer (221, 421) defining a plurality of circuit element pin openings (222, 422) and a plurality of heat dissipating openings (223, 423) therein so that the second grounding conductor layer (220, 420) is exposed from the plurality of circuit element pin openings (222, 422) and the plurality of heat dissipating openings (223, 423);
a plurality of solder balls (224, 424) disposed in the plurality of circuit element pin openings (222, 422) and contacted with the second grounding conductor layer (220, 420); and
a plurality of heat dissipating structures (225, 425) disposed in the plurality of heat dissipating openings (223, 423) and contacted with the second grounding conductor layer (220, 420), the plurality of heat dissipating structures (225, 425) and the plurality of solder balls (224, 424) have an identical material.

3. The circuit board (1) with the a heat dissipating structure according to claim 1, **characterized in that** a material of each of the first grounding conductor layer (210, 410) and the second grounding conductor layer (220, 420) is a copper foil, and the material of the plurality of solder balls (214, 224, 414, 424) and the plurality of heat dissipating structures (215, 225, 415, 425) is a solder paste.

4. The circuit board (1) with a heat dissipating structure according to claim 1, **characterized in that** each of the heat dissipating structures (215, 225, 415, 425) is a projection.

5. A manufacturing method of a circuit board (1) with a heat dissipating structure, **characterized in that** the manufacturing method comprises:
providing a substrate (2, 4) having a first surface (21, 41);
forming a first grounding conductor layer (210, 410) on the first surface (21, 41) of the substrate (2, 4);
forming a first insulting layer (211, 411) on the first grounding conductor layer (210, 410);
defining a plurality of circuit element pin openings (212, 412) and a plurality of heat dissipating openings (213, 413) on in the first insulting layer (211, 411) so that the first grounding conductor layer (210, 410) is exposed from the plurality of circuit element pin openings (212, 412) and the plurality of heat dissipating openings (213, 413); and
forming a plurality of solder balls (214, 414) and a plurality of heat dissipating structures (215, 415) on the first grounding conductor layer (211, 411) by printing a solder material (49) through the plurality of circuit element pin openings (212, 412) and the plurality of heat dissipating openings (213, 413).

6. The manufacturing method of a circuit board (1) with a heat dissipating structure according to claim 5, **characterized in that** the manufacturing method further comprises:
forming a second grounding conductor layer (220, 420) on a second surface (22, 42) of the substrate (2, 4);
forming a second insulting layer (221, 421) on the second grounding conductor layer (220, 420);
defining a plurality of circuit element pin openings (222, 422) and a plurality of heat dissipating openings (223, 423) in the second insulting layer (221, 421) so that the second grounding conductor layer (220, 420) is exposed from the plurality of circuit element pin openings (222, 422) and the plurality of heat dissipating openings (223, 423); and
forming a plurality of solder balls (224, 424) and a plurality of heat dissipating structures (225, 425) on the second grounding conductor layer (220, 420) by printing a solder material (47) through the plurality of circuit element pin openings (222, 422) and the plurality of heat dissipating openings (223, 423).

7. The manufacturing method of a circuit board (1) with a heat dissipating structure according to claim 5, **characterized in that** a material of each of the first grounding conductor layer (210, 410) and the second grounding conductor layer (220, 420) is a copper foil, and the material of the plurality of solder balls (214, 224, 414, 424) and the plurality of heat dissipating structure (215, 225, 415, 425) is a solder paste.

8. The manufacturing method of a circuit board (1) with a heat dissipating structure according to claim 5, **characterized in that** the step of forming the plurality of solder balls (214, 414) and the plurality of heat dissipating structures (215, 415) comprises:
providing a print mask (48) with a plurality of print openings (480) corresponding to the plurality of circuit element pin openings (212, 412) and the plurality of heat dissipating openings (213, 413); and
printing the solder material (49) by using the print mask (48) so that the solder material (49) passes through the plurality of circuit element pin openings (212, 412) and the plurality of heat dissipating openings (213, 413) via the plurality of the print openings (480) to be printed on the first grounding conductor layer (210, 410).
